**Europäisches Patentamt**

**European Patent Office**

**Office européen des brevets**

(19)

(11) Veröffentlichungsnummer: **0 403 691**

**A1**

(12) **EUROPÄISCHE PATENTANMELDUNG**

(21) Anmeldenummer: **89119675.0**

(22) Anmeldetag: **24.10.89**

(51) Int. Cl.⁵: **G01D 13/24, G05B 19/405**

(30) Priorität: **19.06.89 DE 3919927**

(43) Veröffentlichungstag der Anmeldung:
**27.12.90 Patentblatt 90/52**

(84) Benannte Vertragsstaaten:
**DE FR GB IT SE**

(71) Anmelder: **VDO Adolf Schindling AG**
**Gräfstrasse 103**
**D-6000 Frankfurt/Main 90(DE)**

(72) Erfinder: **Kronenberg, Klaus**
**Feldstrasse 9**
**D-6231 Schwalbach/Ts.(DE)**

(74) Vertreter: **Klein, Thomas, Dipl.-Ing. (FH)**
**Sodener Strasse 9 Postfach 6140**
**D-6231 Schwalbach a. Ts.(DE)**

(54) **Verfahren zur Erkennung einer vorbestimmten Zeigerstellung und Anzeigeeinrichtung.**

(57) Es wird ein Verfahren zur Erkennung einer vorbestimmten Zeigerstellung bei einer Anzeigeeinrichtung angegeben, deren Zeiger über ein Getriebe von
einem Drehfeldmotor bewegt wird. Ferner wird eine
Anzeigeeinrichtung angegeben. Bei Anzeigeeinrichtungen dieser Art ist es möglich, daß der Bezug des
ansteuernden Systems zur tatsächlichen Stellung
des Zeigers nicht definiert ist, wenn das System aus
einem beliebigen Zustand heraus gestartet wird. Ziel
der Erfindung ist es, ohne Einsatz von externen
Sensoren den absoluten Bezug zwischen der Zeigerstellung und dem ansteuernden System wieder herzustellen. Dazu wird der Zeiger gegen einen Anschlag bewegt und die Blockierung der Zeigerbewegung wird erkannt. Die Anzeigeeinrichtung weist einen Drehfeldmotor (1) auf, dessen Rotor (2) einen
Magneten (3) aufweist und einen Zeiger bewegt, und
dessen Stator mindestens zwei winkelmäßig gegeneinander versetzte Spulen (4, 5) aufweist, die elektrisch mit einer Steuereinrichtung (6) verbunden
sind. Es ist mindestens ein Umschalter (13) vorgesehen, der die Verbindung einer der Spulen (5) mit der
Steuereinrichtung (6) unterbricht und diese Spule (5)
mit einer Auswerteeinrichtung (14) verbindet.

Fig.1

## Verfahren zur Erkennung einer vorbestimmten Zeigerstellung und Anzeigeeinrichtung

Die Erfindung betrifft ein Verfahren zur Erkennung einer vorbestimmten Zeigerstellung bei einer Anzeigeeinrichtung, deren Zeiger über ein Getriebe von einem Drehfeldmotor bewegt wird sowie eine Anzeigeeinrichtung mit einem Drehfeldmotor, dessen Rotor einen Magneten aufweist und über ein Getriebe einen Zeiger bewegt, und dessen Stator mindestens zwei winkelmäßig gegeneinander versetzte Spulen aufweist, die elektrisch mit einer Steuereinrichtung verbunden sind.

Es ist bekannt, die Zeiger in elektrischen Anzeigeinstrumenten mit Hilfe von sich ändernden magnetischen Feldern zu bewegen. Als Beispiel ist ein Drehspul-Meßinstrument anzuführen, in dem der Zeigerausschlag im wesentlichen von der Größe des durch die felderregende Spule fließenden Stroms bestimmt wird. Man hat auch andere "Motoren" zum Antrieb der Zeiger von Anzeigerichtungen verwen det. Um die Auflösung zu vergrößern und das vom Motor aufzubringende Moment zu verkleinern, ist vorgeschlagen worden, den Motor über ein Getriebe mit dem Zeiger zu verbinden. Ein solches Getriebe kann Übersetzungsverhältnisse in der Größenordnung von 1 zu 10 bis 1 zu 1.000 oder mehr haben. Der Nachteil eines solchen Getriebes ist, daß aus der Rotorposition, d.h. der Winkelstellung des Rotors im Motor, kein zuverlässiger Schluß auf die Zeigerposition gezogen werden kann, wenn der Motor aus einem beliebigen Zustand heraus gestartet wird. Dieser Fall kann beispielsweise dann auftreten, wenn aufgrund eines unvorhergesehenen Zwischenfalls die Zufuhr von elektrischer Leistung unterbrochen wird. Insbesondere in Kraftfahrzeugen kann eine solche Unterbrechung bei Reparaturen an der elektrischen Ausrüstung auftreten, da hier aus Sicherheitsgründen die Batterie vollständig vom elektrischen Bordnetz des Kraftfahrzeugs abgeklemmt werden sollte. Beim Wiedereinschalten, d.h. beim Wiederanklemmen der Batterie, ist der Bezug des ansteuernden Systemes zur tatsächlichen Stellung des Zeigers dann verloren gegangen und nicht mehr definiert. Die Verwendung von externen Sensoren, z.B. induktiven Nährungsschaltern, mechanischen Endschaltern, Lichtschranken o.ä., erlaubt zwar, die Stellung des Zeigers zu ermitteln und an eine Steuerungseinrichtung weiterzumelden. Nachteilig sind dabei jedoch die mit ihrer Verwendung verbundenen höheren Kosten und der zusätzliche Montageaufwand. Insbesondere in Kraftfahrzeugen will man zusätzliche Bauteile aus Gewichtsgründen vermeiden. Oft steht auch der für ihre Unterbringung notwendige Platz nicht zur Verfügung.

Es ist die Aufgabe der Erfindung, ohne Verwendung von externen Sensoren den Bezug der Zeigerstellung zum ansteuernden System zu ermitteln.

Diese Aufgabe wird bei einem Verfahren der eingangs genannten Art dadurch gelöst, daß der Zeiger gegen einen Anschlag bewegt und die Blokkierung der Zeigerbewegung erkannt wird.

Der Zeiger wird also an einen ganz bestimmten, mechanisch festgelegten Punkt bewegt. An diesem Punkt wird die Bewegung blockiert. Durch Erfassen dieser Blockierung ist es möglich, dem ansteuernden System ein Signal zu übermitteln, aus dem hervorgeht, daß der Zeiger nun an einem vorbestimmten Platz angelangt ist, also eine vorbestimmte Stellung eingenommen hat.

Die Blockierung läßt sich grundsätzlich zu jedem Zeitpunkt erkennen. Vorteilhafterweise werden aber dem Drehfeldmotor in einem Antriebssignal-Zuführabschnitt Antriebssignale zum Weiterdrehen des Rotors um ein vorbestimmtes Winkelinkrement zugeführt. Nach dem Antriebssignal-Zuführabschnitt wird in einem Testabschnitt überprüft, ob der Rotor sich gedreht hat. Dies vermeidet eine mechanische Überlastung des Zeigers und des Drehfeldmotors. Insbesondere der Drehfeldmotor wird dadurch thermisch geschont.

Vorteilhafterweise erfolgt die Überprüfung dabei dadurch, daß in dem Testabschnitt die Reaktion des Drehfeldmotors auf ein Testsignal in der augenblicklich eingenommenen Stellung mit der Reaktion des Motors auf ein Testsignal in der zuvor eingenommenen Stellung verglichen wird. Durch die Drehung haben sich die elektrischen und magnetischen Eigenschaften des Motors verändert. Beispielsweise kann sich der Widerstand eines magnetischen Kreises verändert haben, der mit Hilfe von Testsignalen ermittelt werden kann.

Dabei ist es von Vorteil, wenn die beiden Testsignale gleich sind. Es reicht dann aus, eine einzige Art von Testsignalen zu erzeugen, beispielsweise mit einem einzigen Testsignalgenerator. Darüberhinaus läßt sich durch eine einfache Differenzbildung der durch die Reaktion des Motors gewonnenen Ausgangssignale feststellen, ob sich der Motor gedreht hat oder nicht. Wenn sich der Motor nicht gedreht hat, ergibt die Differenz der Ausgangssignale den Wert Null.

In einer bevorzugten Ausführungsform wird das Feld des Drehfeldmotors durch winkelmäßig gegeneinander versetzte ansteuerbare Spulen erzeugt. Die Winkelinkremente betragen dann den halben Winkelabstand zwischen zwei benachbarten Spulen. Dabei sind mindestens zwei Spulen erforderlich, die um 90° gegeneinander versetzt sind. Das Winkelinkrement beträgt demnach hier 45°. Der Motor kann also grundsätzlich nur zwei Stellungen einnehmen, nämlich einmal eine, in der sein Magnet, der als Permanent- oder Elektro-Magnet ausgebildet sein kann, in Ausrichtung mit einer der beiden Spulenachsen ist, und zum anderen in einer Stellung, in der sich die Achse seines Magneten genau zwischen zwei Spulenachsen befindet. Diese beiden ausgezeichneten Stellungen ermöglichen den größten Unterschied bei der Reaktion auf das Testsignal.

In einer vorteilhaften Ausgestaltung des Verfahrens wird im Testabschnitt eine Spule mit dem Testsignal beaufschlagt und aus einer benachbarten Spule wird ein Ausgangssignal gewonnen. Die Kopplung zwischen den beiden Spulen hängt im wesentlichen von der Stellung des Rotors ab. Die stärkste Kopplung ergibt sich beispielsweise dann, wenn sich der Rotor in der Stellung zwischen den beiden Spulen befindet.

Dies ist insbesondere dann von Vorteil, wenn das Testsignal eine Folge von periodischen Schwingungen aufweist. Der Rotor wird dann durch die eine Spule, die mit dem Testsignal beaufschlagt wird, in Schwingungen versetzt und induziert in der anderen Spule eine Wechselspannung, deren Amplitude im wesentlichen von der Stellung des Rotors, d.h. seines Magneten, abhängig ist. Wenn sich die Achse des Magneten bei einer Anordnung mit zwei felderzeugenden Spulen in einem Winkel von 45° zu beiden Spulenachsen befindet, ergibt sich ein Amplitudenmaximum der Spannung des Ausgangssignals.

Die induzierte Spannung in der benachbarten Spule ist natürlich auch von der Amplitude der Schwingung abhängig, mit der der Magnet schwingt. Um eine möglichst große Amplitude zu erreichen, ist es von Vorteil, wenn die Frequenz des Testsignals etwa der Eigenfrequenz des Rotors entspricht.

Vorteilhafterweise ist das Testsignal ein Rechtecksignal. Die Erzeugung eines Rechtecksignals ist mit den wenigstens Schwierigkeiten verbunden. Es reicht aus, die Signalleitung abwechselnd an zwei verschiedene Spannungen, insbesondere mit entgegengesetzter Polarität, zu legen.

Um auch die Stellung ermitteln zu können, aus der der Zeiger an den Anschlag bewegt worden ist, ist in einer bevorzugten Ausführungsform vorgesehen, daß die Anzahl der Rotorumdrehungen gespeichert wird und gegebenenfalls der Rotor nach Ermittlung der Zeigerstellung am Anschlag um die gespeicherte Anzahl von Umdrehungen wieder zurückgedreht wird.

Bei einer Anzeigeeinrichtung der eingangs genannten Art wird die Aufgabe dadurch gelöst, daß die Steuereinrichtung mindestens einen Umschalter aufweist, der die Verbindung einer der Spulen mit der Steuereinrichtung unterbricht und diese Spule mit einer Auswerteeinrichtung verbindet.

Die Steuereinrichtung kann dann nach wie vor ihr Antriebssignal an den Drehfeldmotor senden. Dieses Antriebssignal dreht den Rotor allerdings nicht weiter, sondern versetzt ihn lediglich in Schwingungen, nämlich in Rotationsschwingungen um seine Achse. Diese Schwingungen induzieren in der anderen Spule eine Spannung, die in einer Auswerteeinrichtung ausgewertet werden können.

Es ist allerdings von Vorteil, daß die Steuereinrichtung ein Antriebssignal an den Drehfeldmotor nur dann sendet, wenn sie mit allen Spulen verbunden ist, und ein Testsignal an mindestens eine Spule, wenn sie nicht mit allen Spulen verbunden ist. Das Testsignal läßt sich besser an eine solche Anregungsfunktion anpassen, deren Antwort, d.h. die in der zweiten Spule erzeugte Spannung, leicht auszuwerten ist.

Dabei ist es von Vorteil, daß das Testsignal ein niederfrequentes periodisches Wechselsignal ist. Die Frequenz kann dabei in der Größenordnung von 50 bis 500 Hz liegen.

In einer bevorzugten Ausführungsform weist das Antriebssignal für jede Spule eine periodische Folge von Impulsen auf, wobei die Impulsfolgen, die den einzelnen Spulen zugeführt werden, gegeneinander phasenverschoben sind. Dabei können die Impulse, die die Form von Rechteckblöcken vorbestimmter Länge haben, jeweils positive und negative Polarität annehmen. Nach jedem Impuls hat sich der Rotor des Motors um ein vorbestimmtes Winkelinkrement weitergedreht. Auch wenn die Impulse nur einen einzigen absoluten Amplitudenwert haben, ist es mit dieser Art der Ansteuerung möglich, den Rotor in acht ausgezeichnete Stellungen laufen zu lassen.

Vorteilhafterweise schaltet der Umschalter nach jedem Impuls um und verbindet die eine der Spulen mit der Auswerteeinrichtung. Nach einer vorbestimmten Zeit schaltet er zurück und verbindet diese Spule wieder mit der Steuereinrichtung. Wie oben ausgeführt, nimmt der Rotor nach jedem Impuls eine vorbestimmte, ausgezeichnete Stellung ein. In dieser Stellung wird der Drehfeldmotor mit dem Testsignal beschickt. Es sind dann keine Einrichtungen mehr notwendig, die dafür sorgen, daß der Motor in den gewünschten Positionen anhält.

Mit Vorteil weist die Auswerteeinrichtung eine Maximalwerterfassungseinrichtung auf, die den Maximalwert eines Signals ermittelt, das von der Spule erzeugt wird, die mit der Auswerteeinrichtung verbunden ist. Mit anderen Worten wird die Amplitude der induzierten Spannung ermittelt. Da die Amplituden in den ausgezeichneten Stellungen des Rotors, d.h. in Ausrichtung mit einer der beiden Spulenachsen oder im Winkel von 45° dazu, zumindest annähernd bekannt sind, läßt sich auf diese Weise leicht feststellen, in welcher Ausrichtung der Rotor zu den Spulen steht.

Dabei ist es von Vorteil, daß die Auswerteeinrichtung auch noch eine Speichereinrichtung, die den Maximalwert speichert, und eine Vergleichereinrichtung aufweist, die den augenblicklichen Maximalwert mit einem früheren, gespeicherten Maximalwert vergleicht und ihre Differenz ermittelt. Wenn sich der Rotor gedreht hat, ist eine Differenz vorhanden. Wenn sich der Rotor nicht gedreht hat, ist keine Differenz vorhanden. Anhand des Vorhandenseins dieser Differenz, d.h. mit einem einzigen Signal, läßt sich also zuverlässig feststellen, ob der Zeiger am Anschlag ist oder nicht.

Mit Vorteil ist dabei der Vergleicher mit der Steuereinrichtung verbunden und unterbricht den Antrieb des Drehfeldmotors, wenn der Absolutbetrag der von der Vergleichereinrichtung ermittelten Differenz kleiner als der vorbestimmte Wert ist. Dadurch wird verhindert, daß der Motor wiederholt Versuche unternimmt, den Zeiger über den Anschlag hinaus zu bewegen, was zu Beschädigungen oder thermischen Überlastungen führen könnte.

Die Erfindung wird im folgenden anhand von bevorzugten Ausführungsbeispielen in Verbindung mit der Zeichnung beschrieben. Darin zeigen:

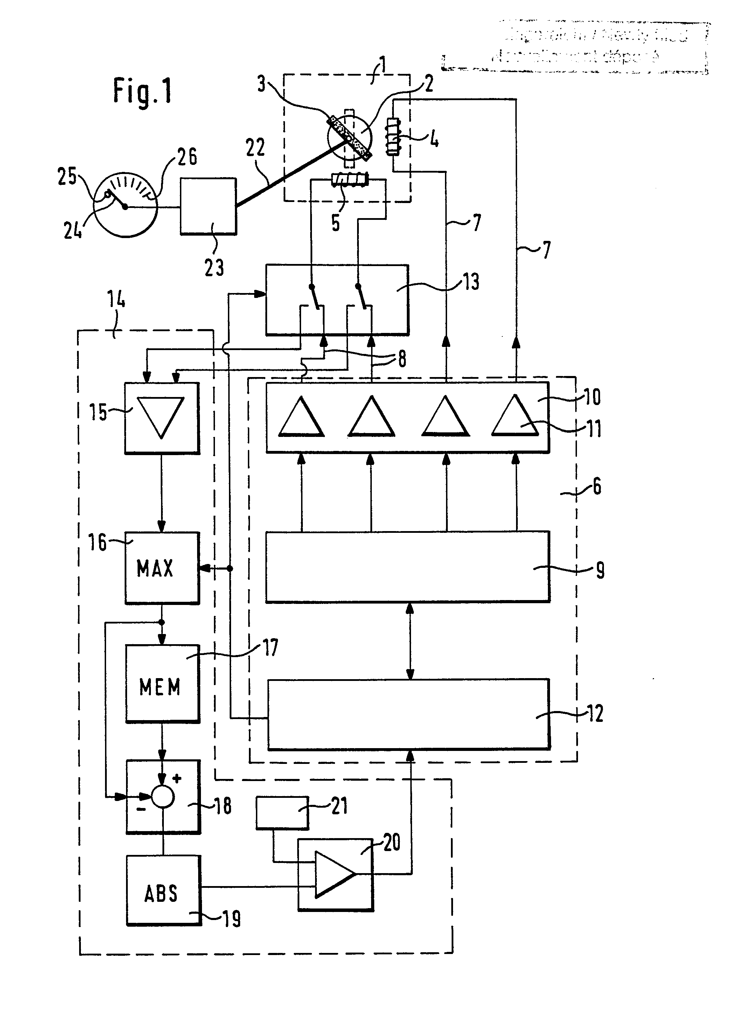

Fig. 1 eine Anzeigeeinrichtung mit Schaltungsanordnung,

Fig. 2 ein Testsignal und ein Ausgangssignal bei Ausrichtung des Rotormagneten mit einer der Spulenachsen,

Fig. 3 das Testsignal und das Ausgangssignal bei einer Stellung des Rotormagneten im Winkel von $45°$ zu den Spulenachsen und

Fig. 4 eine Ansicht ähnlich zu Fig. 2 und 3 mit einer Rechteckfunktion als Testsignal.

Ein Drehfeldmotor 1 weist einen Rotor 2 auf, der einen Magneten 3 trägt. Der Rotor 2 ist über eine Welle 22 mit einem Getriebe 23 verbunden, dessen Ausgangswelle einen Zeiger 24 über eine Skala 26 bewegt. Am linken Ende der Skala 26 ist ein Anschlag 25 vorgesehen, der eine Bewegung des Zeigers 24 weiter nach links blockiert. Der Anschlag kann stattdessen auch am Getriebeabgang vorgesehen sein. Der Magnet 3 ist üblicherweise ein Permanentmagnet, er kann jedoch auch als Elektromagnet ausgebildet sein. Weiterhin weist der Motor 1 zwei Spulen 4, 5 auf, deren Spulenachsen räumlich um $90°$ gegeneinander versetzt sind. Eine Steuereinrichtung 6 erzeugt für jede Spule 4, 5 eine Folge von Impulsen, die der Spule 4 über ein Leitungspaar 7 und der Spule 5 über ein Leitungspaar 8 zugeführt werden. Dazu weist die Steuereinrichtung 6 einen Signalgenerator 9 auf, dessen Signale in einem Verstärker 10 in Treiberstufen 11 verstärkt werden. Der Signalgenerator 9 erzeugt für jede Spule 4, 5 eine Folge von Impulsen in Form von Rechteckblöcken vorbestimmter Länge. Die Amplitude aller Impulse ist gleich groß.

Die Impulse können positive oder negative Polarität annehmen. Erhält beispielsweise die Spule 4 einen positiven Impuls und die Spule 5 gar keinen Impuls, richtet sich der Rotor 3 in der strichliert dargestellten Lage aus. Erhält dagegen die Spule 5 einen negativen Impuls, während die Spule 4 einen positiven Impuls erhält, nimmt der Magnet 3 und damit der Rotor 2 die ausgezogen dargestellte Stellung ein. Die Impulse haben dabei eine vorbestimmte Dauer, damit das resultierende Magnetfeld solange aufgebaut bleibt, bis der Rotor 2 stabil seine neue Position eingenommen hat. Die Steuereinrichtung 6 weist eine Steuerlogik 12 auf, die den Signalgenerator ansteuert. Die Steuerlogik kann beispielsweise mit Hilfe eines Mikroprozessors realisiert sein.

In die Zuführleitung 8 zur Spule 5 ist ein Umschalter 13 eingebaut, der die Verbindung zwischen der Steuereinrichtung 6 und der Spule 5 unterbrechen kann. Gleichzeitig mit der Unterbrechung wird jedoch eine Verbindung zwischen der Spule 5 und einer Auswerteeinrichtung 14 hergestellt. Die Auswerteeinrichtung 14 weist einen Verstärker 15 auf, der ein von der Spule 15 erzeugtes Signal verstärkt. Der Verstärker 15 ist mit einem Maximalwertbildner 16 verbunden, der seinerseits wieder mit einer Speichereinrichtung 17 verbunden ist. Die Speichereinrichtung 17 ist mit dem positiven Eingang eines Substrahierers 18 verbunden. Der negative Eingang des Substrahierers 18 ist ebenfalls mit dem Ausgang des Maximalwertbildners 16 verbunden. Die Speichereinrichtung 17 kann beispielsweise als Schieberegister mit zwei Speicherstellen ausgebildet sein. Damit kann der Substrahierer 18 den augenblicklichen Maximalwert von einem zuvor ermittelten Maximalwert abziehen. Der Maximalwert wird innerhalb eines vorbestimmten Zeitraums ermittelt, der durch die Steuerlogik 12 festgelegt wird. Beispielsweise kann die Amplitude einer Schwingung ermittelt werden.

Der Ausgang des Substrahierers 18 ist mit einem Absolutwertbildner 19 verbunden. Der Ausgang des Absolutwertbildners 19 ist mit einem Eingang eines Komparators 20 verbunden, dessen anderer Eingang mit einem Festwertgeber 21 verbunden ist. Der Ausgang des Komparators 20 ist mit der Steuerlogik 12 verbunden.

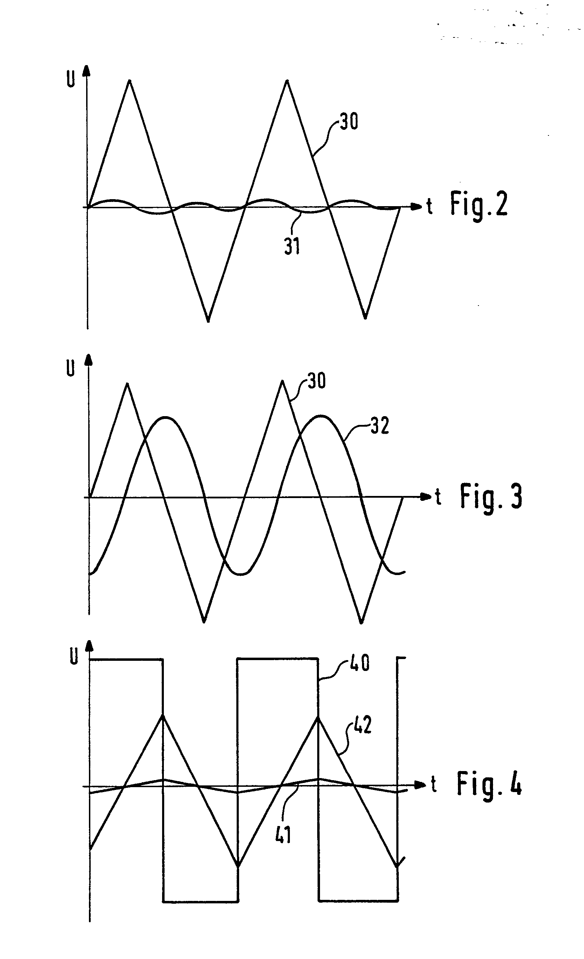

Nach jedem von dem Signalgenerator 9 erzeugten Impuls schaltet die Steuerlogik 12 den Umschalter 13 für eine vorbestimmte Zeit um, so daß die Spule 5 nicht mehr von der Steuereinrichtung 6 versorgt werden kann, sondern mit der Auswerteeinrichtung 14 verbunden ist. Gleichzeitig schaltet die Steuerlogik 12 den Signalgenerator 9 um, der jetzt kein Antriebssignal, sondern ein Testsignal erzeugt. Natürlich kann auch das Antriebssignal als Testsignal verwendet werden. Vorteilhafterweise ist jedoch das Testsignal ein niederfrequentes, periodisches Wechselsignal, beispielsweise in Form einer Sinus-, Dreiecks-, Trapez- oder Reckteckwelle. Dieses Testsignal, das als Dreieckwelle 30 in Fig. 2 und 3 dargestellt ist, regt den Magneten 3 und damit den Rotor 2 zu Schwingungen an. Der schwingende Magnet 3 induziert eine Wechselspannung in der Spule 5, die als Ausgangssignal in der Auswerteeinrichtung 14 ausgewertet werden kann. Die Amplitude des Ausgangssignals ist einerseits abhängig von der Amplitude der Schwingung des Magneten 3 um die Rotorachse. Zum anderen wird sie ganz wesentlich von der Winkellage der Achse des Magneten 3 zu der Hauptachse der Spulen 4, 5 bestimmt. Wenn die Achse des Magneten 3 mit der Achse der Spule 4 ausgerichtet ist, d.h. ein Winkel von 0° zwischen diesen beiden Achsen besteht, ergibt sich als Antwort das in Fig. 2 dargestellte Signal 31. Bei einer Amplitude von 4 V und einer Frequenz von 100 Hz der Anregungsfunktion 30 ergab sich in einem Ausführungsbeispiel eine Ausgangsfunktion mit einer Amplitude von weniger als 40 mV. Befindet sich hingegen die Achse des Magneten 3 in einem Winkel von 45° zu beiden Spulenachsen, ist die induzierte Spannung in der Spule 5 wesentlich größer. Experimentell wurde in einer Ausführungsform eine Amplitude der Ausgangsspannung von 260 mV bei ansonsten gleichen Bedingungen ermittelt (Fig. 3).

Eine andere Möglichkeit der Anregung ist in Fig. 4 dargestellt, wo als anregende Funktion ein Rechteck mit einer Scheitel-Scheitel-Spannung von 4 V und einer Frequenz von 100 Kz verwendet wurde. Die Ausgangsfunktion ergab eine Amplitude von 440 mV, wenn die Achse des Magneten 3 in einem Winkel von 45° zu beiden Spulenachsen stand. Bei einem Winkel von 0° zu einer der beiden Spulenachsen ergab sich eine wesentlich geringere Amplitude der Ausgangsspannung. Bei einer vollständigen Umdrehung des Rotors 2 ergibt sich also bei 0°, 90°, 180°, 270° und 360° eine relativ kleine Amplitude der Ausgangsspannung, während sich bei 45°, 135°, 225° und 315° eine relativ große Amplitude der Ausgangsspannung ergibt.

Durch die Steuerung der Steuerlogik 12 werden immer die Maximalwerte der Amplitude der Ausgangsspannung von Spule 5 bei zwei aufeinanderfolgenden Stellungen des Rotors 2 ermittelt. Der Absolutbetrag der Differenz ist dann weitgehend konstant. Wenn allerdings der Zeiger am Anschlag ist, kann sich der Rotor 2 nicht mehr weiterdrehen. In diesem Fall sind die Maximalwerte der Amplitude der Ausgangsspannung in zwei aufeinanderfolgenden Testabschnitten gleich. Am Ausgang des Substrahierers 18 erscheint der Wert 0. Um zu verhindern, daß genau der Wert 0 erfaßt werden muß, ist durch den Festwertgeber 21 ein gewisser Schwellwert vorgesehen, bei dessen Unterschreiten der Ausgang der Komparators 20 ein Steuersignal erzeugt, das die Steuerlogik 12 davon unterrichtet, daß der Zeiger nunmehr am Anschlag angelangt ist. Die Steuerlogik 12 schaltet dann den Signalgenerator 9 ab, so daß der Rotor 2 nicht weiter von einem Feld belastet wird, das ihn in eine vorbestimmte Richtung zu drehen versucht.

Von der dargestellten Ausführungsform kann in vieler Hinsicht abgewichen werden, ohne den Grundgedanken der Erfindung zu verlassen. Beispielsweise kann der Drehfeldmotor 1 auch durch kontinuierliche Signale angeregt werden. Die Auswerteeinrichtung 14 kann ebenfalls mit Hilfe eines Mikroprozessors realisiert werden, der sogar der gleiche wie in der Steuerlogik 12 sein kann.

## Ansprüche

1. Verfahren zur Erkennung einer vorbestimmten Zeigerstellung bei einer Anzeigeeinrichtung, deren Zeiger über ein Getriebe von einem Drehfeldmotor bewegt wird, dadurch gekennzeichnet, daß der Zeiger gegen einen Anschlag bewegt und die Blockierung der Zeigerbewegung erkannt wird.

2. Verfahren nach Anspruch 1, dadurch gekennzeichnet, daß dem Drehfeldmotor in einem Antriebssignal-Zuführabschnitt Antriebssignale zum Weiterdrehen des Rotors um ein vorbestimmtes Winkelinkrement zugeführt werden und daß nach dem Antriebssignal-Zuführabschnitt in einem Testabschnitt überprüft wird, ob der Rotor sich gedreht hat.

3. Verfahren nach Anspruch 2, dadurch gekennzeichnet, daß die Überprüfung dadurch erfolgt, daß in dem Testabschnitt die Reaktion des Drehfeldmotors auf ein Testsignal in der augenblicklich eingenommenen Stellung mit der Reaktion des Motors auf ein Testsignal in der zuvor eingenommenen Stellung verglichen wird.

4. Verfahren nach Anspruch 3, dadurch gekennzeichnet, daß die beiden Testsignale gleich sind.

5. Verfahren nach einem der Ansprüche 2 bis 4, dadurch gekennzeichnet, daß das Feld des Drehfeldmotors durch winkelmäßig gegeneinander versetzte, ansteuerbare Spulen erzeugt wird und daß die Winkelinkremente den halben Winkelabstand zwischen zwei benachbarten Spulen betragen.

6. Verfahren nach Anspruch 5, dadurch gekennzeichnet, daß im Testabschnitt eine Spule mit dem Testsignal beaufschlagt wird und aus einer benachbarten Spule ein Ausgangssignal gewonnen wird.

7. Verfahren nach Anspruch 6, dadurch gekennzeichnet, daß das Testsignal eine Folge von periodischen Schwingungen aufweist.

8. Verfahren nach Anspruch 7, dadurch gekennzeichnet, daß die Frequenz des Testsignals etwa der Eigenfrequenz des Rotors entspricht.

9. Verfahren nach Anspruch 7 oder 8, dadurch gekennzeichnet, daß das Testsignal ein Rechtecksignal ist.

10. Verfahren nach einem der Ansprüche 1 bis 9, dadurch gekennzeichnet, daß die Anzahl der Rotorumdrehungen gespeichert wird und gegebenenfalls der Rotor nach Ermittlung der Zeigerstellung am Anschlag um die gespeicherte Anzahl von Umdrehungen wieder zurückgedreht wird.

11. Anzeigeeinrichtung mit einem Drehfeldmotor, dessen Rotor einen Magneten aufweist und über ein Getriebe einen Zeiger bewegt, und dessen Stator mindestens zwei winkelmäßig gegeneinander versetzte Spulen aufweist, die elektrisch mit einer Steuereinrichtung verbunden sind, dadurch gekennzeichnet, daß die Steuereinrichtung (6) mindestens einen Umschalter (13) aufweist, der die Verbindung einer der Spulen (5) mit der Steuereinrichtung (6) unterbricht und diese Spule (5) mit einer Auswerteeinrichtung (14) verbindet.

12. Anzeigeeinrichtung nach Anspruch 11, dadurch gekennzeichnet, daß die Steuereinrichtung (6) ein Antriebssignal an den Drehfeldmotor (1) sendet, wenn sie mit allen Spulen (4, 5) verbunden ist, und ein Testsignal an mindestens eine Spule (4), wenn sie nicht mit einer Spule (4, 5) verbunden ist.

13. Anzeigeeinrichtung nach Anspruch 11 oder 12, dadurch gekennzeichnet, daß das Testsignal ein niederfrequentes periodisches Wechselsignal (30, 40) ist.

14. Anzeigeeinrichtung nach einem der Ansprüche 11 bis 13, dadurch gekennzeichnet, daß das Antriebssignal für jede Spule eine periodische Folge von Impulsen aufweist, wobei die Impulsfolgen, die den einzelnen Spulen (4, 5) zugeführt werden, gegeneinander phasenverschoben sind.

15. Anzeigeeinrichtung nach Anspruch 14, dadurch gekennzeichnet, daß der Umschalter (13) nach jedem Impuls umschaltet und die eine der Spulen (5) mit der Auswerteeinrichtung (14) verbindet und nach einer vorbestimmten Zeit zurückschaltet und diese Spule (5) mit der Steuereinrichtung (6) verbindet.

16. Anzeigeeinrichtung nach einem der Ansprüche 11 bis 15, dadurch gekennzeichnet, daß die Auswerteeinrichtung (14) eine Maximalwerterfassungseinrichtung (16) aufweist, die den Maximalwert eines Signals ermittelt, das von der Spule (5) erzeugt wird, die mit der Auswerteeinrichtung (14) verbunden ist.

17. Anzeigeeinrichtung nach Anspruch 16, dadurch gekennzeichnet, daß die Auswerteeinrichtung (14) eine Speichereinrichtung (17), die den Maximalwert speichert, und eine Vergleichereinrichtung (18) aufweist, die den augenblicklichen Maximalwert mit einem früheren gespeicherten Maximalwert vergleicht und ihre Differenz ermittelt.

18. Anzeigeeinrichtung nach Anspruch 17, dadurch gekennzeichnet, daß die Vergleichereinrichtung (18) mit der Steuereinrichtung (6) verbunden ist und den Antrieb des Drehfeldmotors (1) unterbricht, wenn der Absolutbetrag der von der Vergleichereinrichtung (18) ermittelten Differenz kleiner als ein vorbestimmter Wert ist.

Fig.1

Reproduit à l'identité lisible
intégralement déposé

Fig. 2

Fig. 3

Fig. 4

| | Europäisches Patentamt | EUROPÄISCHER RECHERCHENBERICHT | Nummer der Anmeldung |
|---|---|---|---|
| | | | EP 89 11 9675 |

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | US-A-3 870 274 (M. BROE) * Spalte 1, Zeile 44 - Spalte 2, Zeile 28; Figur 1 * | 1 | G 01 D 13/24 G 05 B 19/405 |
| A | --- | 5,11 | |
| Y | PATENT ABSTRACTS OF JAPAN, Band 4, Nr. 35 (P-003), 25. März 1980; & JP-A-55 009 141 (YAZAKI CORP.) 23-01-1980 --- | 1 | |
| A | IDEM ----- | 5,11,12 | |

| | | RECHERCHIERTE SACHGEBIETE (Int. Cl.5) |
|---|---|---|
| | | F 16 K G 01 D G 01 R |

Der vorliegende Recherchenbericht wurde für alle Patentansprüche erstellt

| Recherchenort | Abschlußdatum der Recherche | Prüfer |
|---|---|---|
| DEN HAAG | 08-10-1990 | CHAPPLE I.D. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument

......................................................................
& : Mitglied der gleichen Patentfamilie, übereinstimmendes Dokument

EPO FORM 1503 03.82 (P0403)